# EUROPEAN PATENT SPECIFICATION

(11) **EP 4 414 730 B1**
(45) Date of publication and mention of the grant of the patent: **22.04.2026**
(21) Application number: 23872718.4
(22) Date of filing: 29.06.2023
(51) Int. Cl.: G01R 31/396, G01R 31/382, G01R 31/371, G01R 19/165, G01R 31/392, G01R 31/367, H01M 10/48, H02J 7/00

(54) **ENERGY STORAGE SYSTEM FOR RESPONDING TO ABNORMAL COMMUNICATION SITUATION AND METHOD THEREOF**
ENERGIESPEICHERSYSTEM ZUR REAKTION AUF EINE UNNORMALE KOMMUNIKATIONSSITUATION UND VERFAHREN DAFÜR
SYSTÈME DE STOCKAGE D'ÉNERGIE POUR RÉAGIR À UNE SITUATION DE COMMUNICATION ANORMALE ET SON PROCÉDÉ ASSOCIÉ

(30) Priority: 27.09.2022 KR 20220122240; 13.02.2023 KR 20230018665
(43) Date of publication of application: 14.08.2024
(73) Proprietor: LG Energy Solution, Ltd., Seoul 07335 (KR)
(72) Inventor: PARK, Jeong Seok, Daejeon 34122 (KR); SONG, Youngdoo, Daejeon 34122 (KR); HWANG, Yunseong, Daejeon 34122 (KR)
(74) Representative: Plasseraud IP
(86) International application number: PCT/KR2023/009138
(87) International publication number: WO 2024/071592

(56) References cited:
- JP-A- 2009 272 047
- JP-A- 2015 117 990
- KR-A- 20170 056 061
- KR-A- 20190 015 925
- KR-A- 20220 013 137
- US-A1- 2014 152 267
- US-A1- 2017 253 140
- US-A1- 2018 097 375

## Description

### [Technical Field]

The present invention relates to an energy storage system comprising a battery control apparatus capable of stably operating the energy storage system in a loss of communication situation and a method for controlling the energy storage system

### [Background Art]

A secondary battery is a battery that can be recharged and reused even after being discharged. The secondary battery can be used as an energy source for small devices such as mobile phones, tablet PCs and vacuum cleaners, and also used as an energy source for medium and large devices such as an energy storage system (ESS) for automobiles and smart grids.

The secondary battery is applied to a system in a form of an assembly such as a battery module in which a plurality of battery cells are connected in series and parallel or a battery pack in which battery modules are connected in series and parallel according to system requirements.

An integrated control device (or upper control device) in an energy storage system monitors and controls battery assemblies based on battery state information such as state of charge (SOC) collected from the battery assemblies. An example of a control device in an energy storage system can be found for instance in US 2018/097375 A1 or US 2017/253140 A1. Here, if a specific battery assembly experiences a loss of communication (LOC), the integrated control device is unable to receive battery state information from the corresponding battery assembly, and accordingly, the control the energy storage system becomes impossible. In this case, the operation of the energy storage system must be stopped to carry out maintenance on a module experiencing a loss of communication. Meanwhile, in the case of an energy storage system which employs lithium iron phosphate (LFP) batteries, it is necessary to fully charge or fully discharge battery assemblies so that the battery assemblies are connected in parallel to each other when the whole battery assemblies are of the same SOC.

In order to solve these problems of the prior art, an appropriate control solution is required to stably operate the energy storage system without stopping the energy storage system when a loss of communication occurs in a specific battery assembly.

### [Detailed Description of the Invention]

### [Technical Problem]

To obviate one or more problems of the related art, embodiments of the present disclosure provide a battery control apparatus capable of stably operating an energy storage system without stopping the energy storage system when a loss of communication occurs in a specific battery assembly.

To obviate one or more problems of the related art, embodiments of the present disclosure also provide a battery control method using the battery control apparatus.

To obviate one or more problems of the related art, embodiments of the present disclosure also provide an energy storage system including the battery control apparatus.

### [Technical Solution]

The present invention provides an energy storage system as defined by independent claim 1 and a battery control method as defined by independent claim 7. Preferred embodiments are defined in the appended dependent claims.

### [Advantageous Effects]

According to embodiments of the present disclosure, the energy storage system can be stably operated without stopping even if a loss of communication situation occurs in a specific battery assembly.

### [Brief Description of the Drawings]

FIG. 1 is a block diagram of a general energy storage system.
FIG. 2 shows a charging characteristic curve of the LFP battery.
FIG. 3 is an operational flowchart of a general operating method of an energy storage system when a loss of communication occurs.
FIG. 4 is a block diagram of an energy storage system according to embodiments of the present invention.
FIG. 5 is an operation flowchart of a battery control method of a battery control apparatus according to embodiments of the present invention.
FIG. 6 is an operation flowchart of a method for selecting a reference battery according to embodiments of the present invention.
FIG. 7 is a reference table for explaining a method for selecting a reference battery according to embodiments of the present invention.
FIG. 8 is a block diagram of a battery control apparatus according to embodiments of the present invention.
   100: battery
   200: BMS
   300: upper control apparatus
   310: storage device
   800: battery control apparatus

### [Best Modes for Practicing the Disclosure]

The present invention may be modified in various forms and have various embodiments, embodiments within the scope of the appended claims, and specific embodiments thereof are shown by way of example in the drawings and will be described in detail below.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a minimum unit that serves to store power and a battery module refers to an assembly in which a plurality of battery cells are electrically connected.

A battery rack refers to a system of a minimum single structure which is assembled by electrically connecting module units, set by a battery manufacturer, and can be monitored and controlled by a battery management apparatus/system (BMS). A battery rack may include several battery modules and a battery protection unit or any other protection device.

A battery bank refers to a group of large-scale battery rack systems configured by connecting several racks in parallel. A bank BMS for a battery bank may monitor and control rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

A battery system controller (BSC) is a top-level control device that controls a battery system including a battery bank or a battery system with a multiple bank level structure.

State of charge (SOC) refers to a current state of charge of a battery, represented in percent points [%], and State of Health (SOH) may be a current condition of a battery compared to its ideal or original conditions, represented in percent points [%].

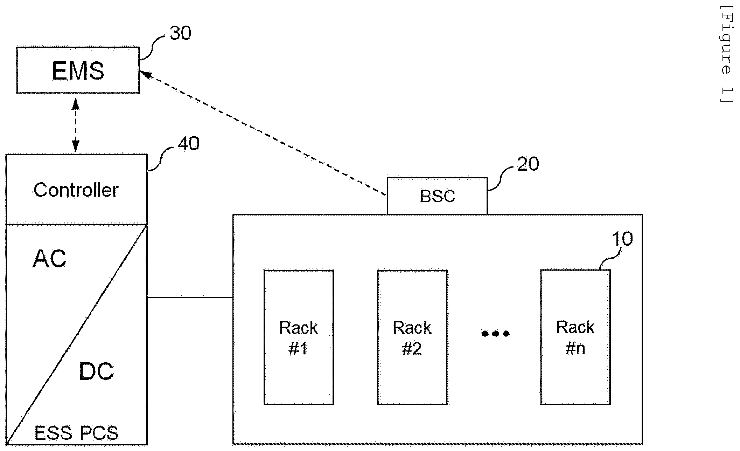

FIG. 1 is a block diagram of a general energy storage system.

In an energy storage system (ESS), typically a battery cell is a minimum unit of storing energy or power. A series/parallel combination of battery cells may form a battery module, and a plurality of battery packs may form a battery rack. In other words, a battery rack can be a minimum unit of a battery system as a series/parallel combination of battery packs. Here, depending on a device or a system in which the battery is used, a battery pack may be referred to as a battery module.

Referring to FIG. 1, a battery rack 10 may include a plurality of battery modules and a battery protection unit (BPU) or any other protection device. The battery rack can be monitored and controlled through a rack BMS (RBMS). The RBMS may monitor a current, a voltage and a temperature, among others, of each battery rack to be managed, calculate a state of charge (SOC) of the battery based on monitoring results, and control charging and discharging of the battery rack.

The battery protection unit (BPU) is a device for protecting the battery rack from an abnormal current and a fault current in the battery rack. The BPU may include a main contactor (MC), a fuse, and a circuit breaker (CB) or a disconnect switch (DS). The BPU may control a battery system rack by rack through on/off controlling the main contactor (MC) based on a control from the Rack BMS. The BPU may also protect the battery rack from a short circuit current using a fuse in the event of a short circuit. As such, the battery system can be controlled through a protection device such as a BPU or a switchgear.

A battery system controller (BSC) 20 is located in each battery section which includes a plurality of batteries, peripheral circuits, and devices to monitor and control objects such as a voltage, a current, a temperature, and a circuit breaker. The battery system controller is an uppermost control apparatus in a bank level battery system including a plurality of battery racks. The battery system controller may also be used as a control apparatus in a battery system having a plurality of bank level structures.

A power conversion system (PCS) 40 installed in each battery section performs charging/discharging based on a charge/discharge command (e.g., a charge or discharge command) from the energy management system (EMS) 30. The power conversion system (PCS) 40 may include a power conversion unit (DC/AC inverter) and a controller. The output of each BPU may be connected to the PCS 40 through a DC bus, and the PCS 40 may be connected to a power grid. In addition, the EMS(or Power Management System (PMS)) 30 may manage the overall energy storage system (ESS).

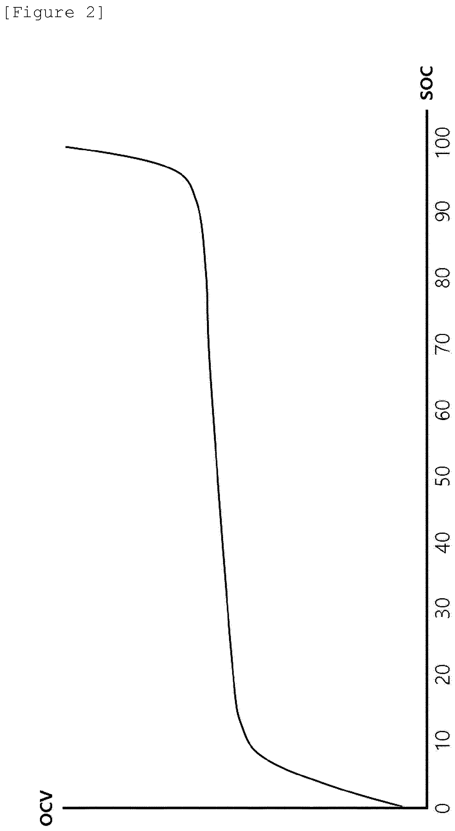

FIG. 2 shows a charging characteristic curve of an LFP battery.

Carbon materials are mainly used as an anode active material of lithium secondary batteries whereas lithium-containing cobalt oxide (LiCoO2) is mainly used as a cathode active material and lithium-containing manganese oxides (LiMnO2, LiMn2O4, etc.) and lithium-containing nickel oxide (LiNiO2) are also being considered.

Recently, a lithium iron phosphate (LiFePO4)-based compound has been used as a cathode active material for a lithium secondary battery. A lithium iron phosphate (LFP) battery using lithium iron phosphate as a cathode active material is superior in terms of thermal stability and cost efficiency compared to other types of batteries.

During operation of the energy storage system, balancing control or charge/discharge control may be performed based on SOCs of batteries. Here, a method of measuring an open-circuit voltage value of the battery and estimating the SOC of the battery based on the measured open-circuit voltage value is mainly used, in order to calculate the SOC of a battery.

FIG. 2 shows a charging characteristic curve which represents a correspondence between an open circuit voltage (OCV) and a SOC measured during a battery charging process.

Referring to FIG. 2, the charging characteristic curve of the LFP battery has a voltage plateau in the SOC range of about 10% to about 90%. In the case of an LFP battery having such a plateau characteristic, it is difficult to accurately estimate the SOC in the plateau section, accurate estimation is possible only in a non-plateau section (e.g., a section where the SOC is 90% or more, or a section where the SOC is 10% or less). In other words, in a battery system to which the LFP battery is applied, accurate SOC estimation is possible only in a very limited SOC section.

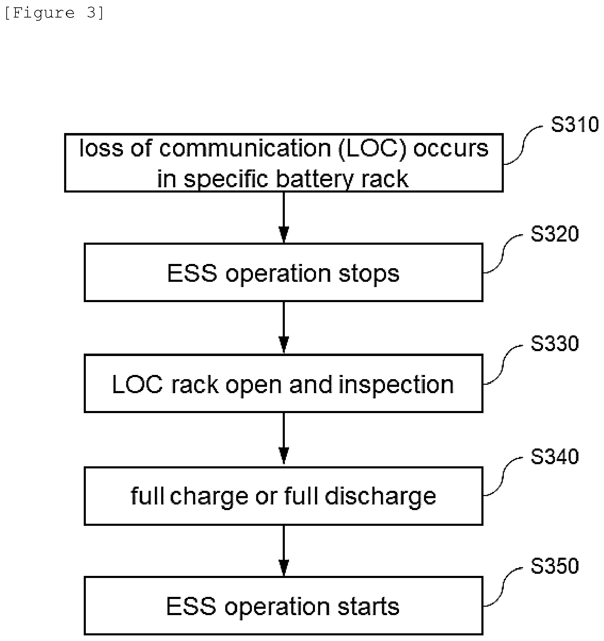

FIG. 3 is an operational flowchart of a general operating method of an energy storage system when a loss of communication occurs.

An upper control apparatus (e.g., BSC or EMS) of the energy storage system may monitor and control battery racks based on SOCs collected from RBMSs. Here, when a loss of communication (LOC) occurs in a specific battery rack (S310), the upper control apparatus cannot receive the SOC from the RBMS of the corresponding battery rack (rack with LOC).

As the SOC of the battery rack in which a loss of communication occurred is omitted, the operation of the energy storage system becomes impossible, the operation of the energy storage system is stopped (S320), and the corresponding battery rack is opened for performing inspection and maintenance work so as to resolve the loss of communication situation (S330).

When the loss of communication state of the corresponding battery rack is resolved, the battery rack may be reconnected to the energy storage system. Here, for stable operation of the energy storage system, the corresponding battery rack needs to be reconnected to the energy storage system when the SOCs of the corresponding battery rack and other battery racks are very similar.

Here, in the case of battery racks with LFP batteries, battery racks need to be fully charged or fully discharged because accurate estimation of SOC is possible only in non-flat sections (e.g., a section with SOC of 90% or more, or a section with SOC of 10% or less) (S340). Then, when the battery racks are electrically connected, the energy storage system may be re-operating (S350).

In other words, when loss of communication occurs in a specific battery rack during operation of the energy storage system, the entire system is stopped and a full charge or full discharge process must be performed, and thus, it takes a considerable amount of time to re-operate the system.

The present invention is presented to solve this problem and relates to a battery control apparatus and an energy storage system including the same, which can stably operate the energy storage system without stopping even if a loss of communication occurs in a specific battery assembly.

Hereinafter, preferred embodiments according to the present invention will be described in detail with reference to the accompanying drawings.

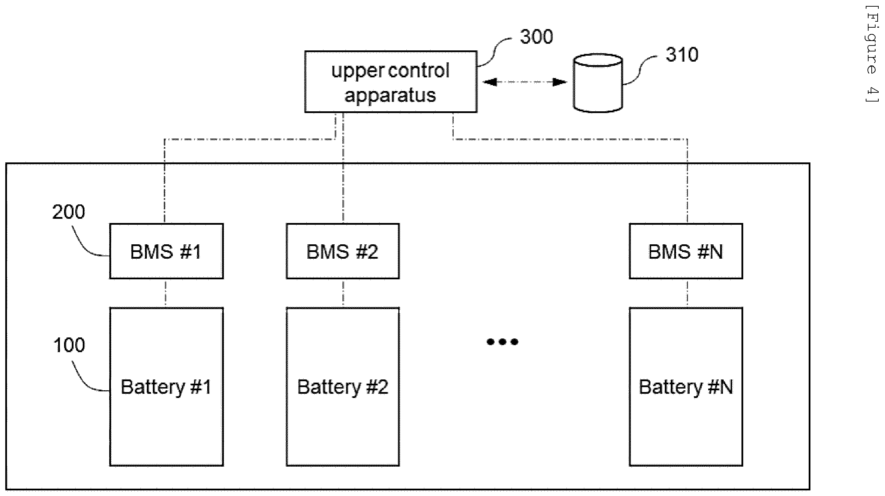

FIG. 4 is a block diagram of an energy storage system according to embodiments of the present invention.

Referring to FIG. 4, the energy storage system according to the present invention includes a plurality of batteries 100 and a plurality of battery management systems (BMSs) provided in correspondence to the plurality of batteries, respectively, and for managing and controlling corresponding batteries (200).

The plurality of batteries 100 are electrically connected to each other in parallel.

In the present disclosure, the battery 100 may mean a battery assembly. In other words, the battery 100 according to the present invention may correspond to a battery module, a battery pack, a battery rack, or a battery bank.

In embodiments, the battery 100 may correspond to a battery assembly including one or more battery cells (e.g., LFP battery cells) having at least a portion of a voltage plateau section in a charging characteristic curve.

The BMS 200 may manage and control its corresponding battery 100 by collecting state information on the corresponding battery 100 and performing a predefined control operation based on the collected state information. Here, the BMS 200 may control charging and discharging of the battery based on the state information of the battery and diagnose whether the battery cells are out of order.

Each of the plurality of BMSs 200 may be connected to an upper control apparatus 300 through a network, transmit battery state information such as SOC of the battery to the upper control apparatus 300, receive control commands from the upper control apparatus 300, and operate based on the received control commands.

The upper control apparatus 300 collects state information on a plurality of batteries from the plurality of BMSs 200 and monitor or control the plurality of batteries based on the collected state information. Here, the upper control apparatus 300 may correspond to a battery system controller (BSC), an energy management system (EMS), or a power management system (PMS).

When a loss of communication occurs in a specific battery (first battery) and the upper control apparatus 300 cannot receive status information from the BMS (first BMS) corresponding to the battery, the upper control apparatus 300 operates the energy system by selecting reference batteries (second battery) which are estimated as having states similar to that of the specific battery (first battery) and estimating state information of the specific battery with loss of communication (first battery) based on the state information of the selected reference batteries (second battery).

In other words, the upper control apparatus 300 is configured to monitor or control a plurality of batteries by estimating state information of a specific battery with loss of communication (first battery) based on the state information of the selected one or more reference batteries (second battery) and using the estimated state information as state information of the specific battery with loss of communication (first battery), without stopping the operation of the energy storage system even if state information of the specific battery is not received from a specific BMS (first BMS).

The upper control apparatus 300 selects a plurality of second batteries among batteries which are connected in parallel with the first battery, based on history information of the batteries stored in the storage device 310. The upper control apparatus 300 selects a plurality of batteries having an operating pattern similar to the first battery and determine the batteries as the second battery, by using history information on one or more of SOC, cumulative charge/discharge amount, and temperature values of the plurality of batteries which are connected in parallel with the first battery and stored in the storage device 310.

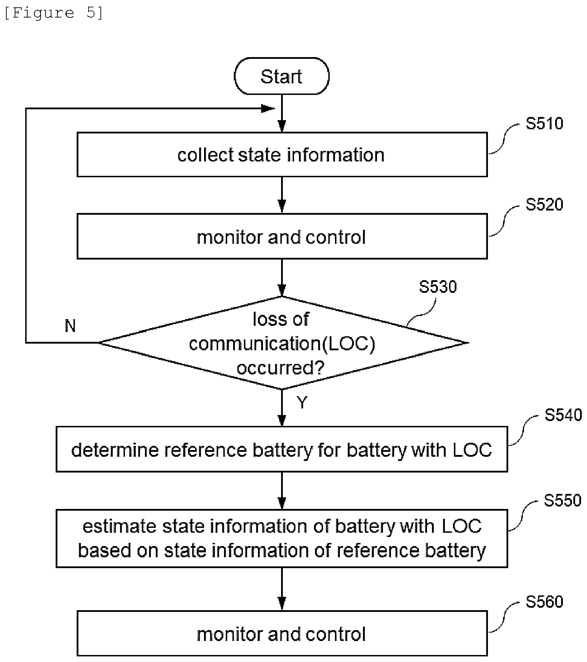

FIG. 5 is an operational flowchart of a battery control method of a battery control apparatus according to embodiments of the present invention.

The control method shown in FIG. 5 is performed in a battery control apparatus that interworks with a plurality of BMSs provided in correspondence to a plurality of batteries, respectively. Here, the battery control apparatus may be an upper control apparatus for a plurality of BMSs, and may correspond to, for example, a battery system controller (BSC), an energy management system(EMS), or a power management system (PMS).

The battery control apparatus collects state information on a plurality of batteries from a plurality of BMSs (S510). Here, the state information include one or more of a battery SOC, a voltage value, a current value, a charge/discharge amount, and a temperature value.

The battery control apparatus may monitor or control the plurality of batteries based on the collected state information (S520). For example, the battery control apparatus may control charging and discharging of each battery based on the collected state information.

The battery control apparatus detects whether a loss of communication has occurred in a specific battery among a plurality of batteries (S530). Here, the battery control apparatus determines that a loss of communication has occurred in a specific battery when state information is not received from the specific battery.

When a loss of communication occurs in a specific battery (first battery) and state information is not received from the BMS (a first BMS) that manages the battery (Y in S530), the battery control apparatus designates reference batteries (second battery) for the battery experiencing a loss of communication (S540). A plurality of reference batteries (second batteries) are determined.

The battery control apparatus selects second batteries based on history information of batteries stored in the storage device.

The battery control apparatus determines the second battery among a plurality of batteries by using history information for a predetermined period of time. Here, the history information include history data on one or more of SOC, a temperature value, and a cumulative charge/discharge amount. For example, the battery control apparatus may select a plurality of second batteries having operation patterns similar to that of the first battery by using history data on SOC, a temperature value, or a cumulative charge/discharge amount for a period of 3 days before the occurrence of the loss of communication.

The battery control apparatus compares history information of the first battery with history information of batteries connected in parallel with the first battery, calculate a degree of similarity with the first battery, and determine a plurality of second batteries based on the calculated degree of similarity. The battery control apparatus calculates a difference between state values (e.g., SOC, temperature value, or cumulative charge/discharge amount) for each time point included in the history data, accumulates the calculated differences, and calculates the similarity based on the accumulated differences. Here, the degree of similarity may be calculated as a higher value as the accumulated difference value becomes lower.

The battery control apparatus compares history information of the first battery with history information of top N batteries (N is a predetermined natural number equal to or greater than 2) that are close to the first battery, calculate similarity to the first battery, and determine second batteries based on the calculated similarity. Here, the battery control apparatus determines top M batteries having a high similarity to the first battery (M is a predetermined natural number of 2 or more) as the second batteries. For example, the battery control apparatus may calculate the similarity of top 6 batteries which are located close to the first battery and select top 3 batteries having a high similarity as the second batteries.

In the embodiments, the battery control apparatus may exclude a battery among batteries connected in parallel with the first battery from comparison, the battery having a failure history recorded within a predetermined period. For example, a battery with a history record of occurrence of an abnormal voltage or detection of an ignition event for a period of 3 days before the time of a loss of communication occurrence may be excluded from candidates for the second battery.

The battery control apparatus may estimate state information of the first battery based on the state information of the one or more selected second batteries (S550).

Upon only one second battery, the battery control apparatus may estimate state information of the second battery as state information of the first battery.

Upon a plurality of second batteries, the battery control apparatus calculates an average value or a median value of pieces of state information of the selected second batteries and estimate the calculated value as state information of the first battery. The battery control apparatus estimates an average value or a median value of SOCs of respective selected second batteries as the SOC of the first battery.

The battery control apparatus may monitor or control a plurality of batteries by using state information estimated based on the state information of second batteries as state information of the first battery without stopping the operation of the energy storage system (S560). For example, the battery control apparatus may operate the energy storage system by using the SOC of the second battery as the SOC of the first battery.

The battery control apparatus may record state information estimated based on the state information of the second battery as state information of the first battery in a storage device during a period in which any state information of the first battery is not received.

In an embodiment, when a failure occurs in a specific battery among the second batteries after the plurality of second batteries are selected, the battery control apparatus may replace the failed battery with a battery having a similarity of the priority and renew the second battery. For example, upon a loss of communication in Rack #1, top 3 racks (Racks #2 to #4) with a high similarity may be selected as reference racks among top 6 racks (Racks #2 to #7) in close proximity to Rack #1 and the energy storage system may be operated by using the average SOC value of Racks #2 to #4 may as the SOC of Rack #1. If a failure occurs in Rack #2 during operation of the energy storage system, Rack #5, which has the next highest similarity other than Racks #2 to 4, can be substituted as a reference battery.

The battery control apparatus may check whether the loss of communication state of the first battery is released. Here, the battery control apparatus may determine that the loss of communication state of the first battery is released when state information is received from the first BMS.

When the loss of communication state with respect to the first battery is released, the battery control apparatus may not use the estimated state information as the state information of the first battery, but monitor and control the batteries using state information of each of the batteries.

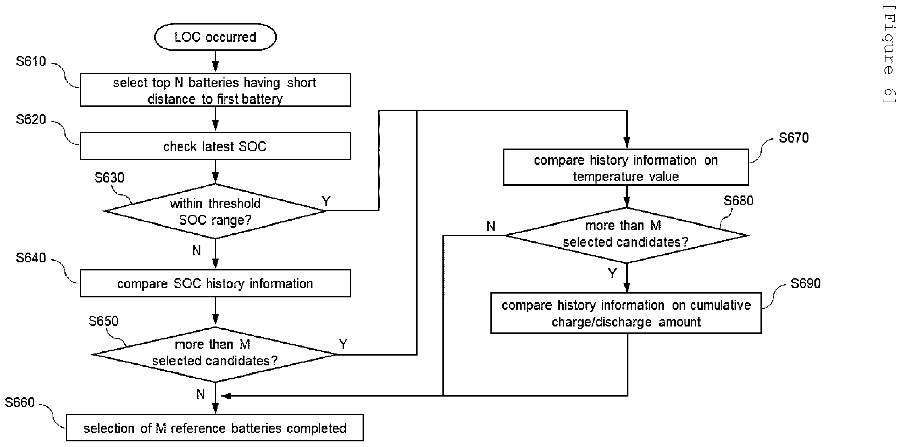

FIG. 6 is an operational flowchart of a method for selecting a reference battery according to embodiments of the present invention.

The battery control apparatus determines a plurality of second batteries among a plurality of batteries connected in parallel with the first battery by using history information for a predetermined period of time. Here, the history information includea history data on one or more of SOC, a temperature value, and cumulative charge/discharge amount.

In the embodiments, the battery control apparatus may determine the plurality of second batteries based on a distance to the first battery, a SOC immediately before a loss of communication occurs, and predefined priorities assigned to each history data item. Here, the priorities may be predefined in a sequence starting with SOC, followed by a temperature value and cumulative charge/discharge amount.

Referring to FIG. 6, when a loss of communication occurs in a specific battery (first battery) and state information is not received from the BMS (first BMS) managing the battery, the battery control apparatus may determine that a loss of communication has occurred in the first battery.

The battery control apparatus selects the top N batteries (where N is a preset natural number equal to or greater than 2) with the shortest distance from the first battery among the batteries connected in parallel with the first battery (S610). Here, the battery control apparatus may calculate a distance to the first battery based on an identifier of each battery and arrangement information between the batteries stored in a storage device and select top N batteries with a short distance.

The battery control apparatus may check the latest SOC of the first battery or the selected N batteries (S620). For example, if a loss of communication occurs, the battery control apparatus may check the SOC of each battery which is last recorded in the storage device.

The battery control apparatus may check whether the identified latest SOC is within a threshold SOC range which is predefined as an SOC estimation impossible section (S630). Here, the threshold SOC range may be predefined as an SOC section in which an **amount of voltage change** versus an amount of SOC change is less than or equal to a predefined threshold value in a SOC and voltage correspondence curve of the battery, which may be defined for example, as a section of SOC greater than 10 and less than 90.

If the latest identified SOC is out of the threshold SOC range (N in S630), the battery control apparatus may compare SOC history information between the first battery and the selected N batteries (S640) to determine the top M batteries with a high similarity. For example, if the latest SOC of the first battery is out of the threshold SOC range (i.e., when a loss of communication occurs while the SOC of the first battery can be estimated), the battery control apparatus may determine the plurality of second batteries by comparing history information of SOCs which is predefined as the first priority comparison item.

Here, upon M batteries having a high similarity to the history information on the SOC of the first battery (N in S650), the M batteries may be determined as the second batteries (S660).

On the other hand, in the instance that the number of upper batteries having a high similarity to the SOC history information of the first battery exceeds M (Y in S650), the battery control apparatus may determine M batteries, among corresponding batteries, having the a high similarity to history information on one or more of a temperature value and a cumulative charge/discharge amount of the first battery as the second batteries (S670 to s690). In other words, if M reference batteries cannot be determined as a result of comparing the SOC history information which is predefined as the first priority comparison item because of batteries having a same degree of similarity, the battery control apparatus may determine M reference batteries by sequentially comparing the history items of the next priority.

For example, if the count of batteries exhibiting a high similarity to the SOC history information of the first battery exceeds M, the battery control apparatus may determine M batteries having a high degree of similarity by comparing history information on the temperature values (second priority) between the first battery and other corresponding batteries (S670). If the number of batteries having a high similarity to the history information on the temperature value of the first battery exceeds M (Y in S680), the battery control apparatus may determine M batteries having a high degree of similarity by comparing history information on cumulative charge/discharge amount (third priority) between the first battery and other corresponding batteries (S690). Here, once M batteries are selected, the process of selecting reference batteries may be completed (S660). Meanwhile, if M batteries are not selected even through the comparison of cumulative charge/discharge amounts, the top M batteries which are located close to the first battery among batteries having the same similarity may be finally selected as the second batteries.

In S630, when the identified latest SOC is within a threshold SOC range (Y in S630), the battery control apparatus may determine the top M batteries having a high similarity with the history information on one or more of the temperature value and the cumulative charge/discharge amount of the first battery as second batteries (S670 to S690). For example, if the latest SOC of the first battery is within the threshold SOC range (i.e., when a loss of communication occurs in a state in which the SOC of the first battery cannot be estimated), the battery control apparatus may determine reference batteries by sequentially comparing history items of the next priorities without comparing SOC history information which is predefined as the first priority.

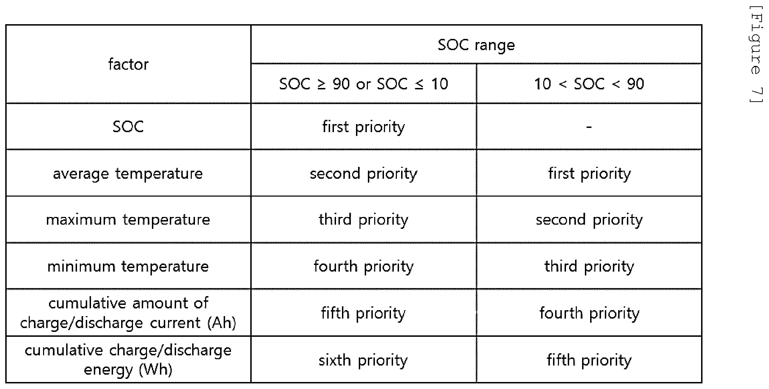

FIG. 7 is a reference table for explaining a method for selecting a reference battery according to embodiments of the present invention.

In embodiments, comparison priorities for each of the SOC estimation impossible section and the history items may be predefined for selection of the reference battery. Here, the battery control apparatus may select reference batteries for a battery having a loss of communication based on the SOC estimation impossible section stored in the storage device and the comparison priority.

For example, referring to FIG. 7, the SOC estimation impossible section (threshold SOC range) may be defined as a section of SOC greater than 10 and less than 90.

In addition, the history items to be compared may include SOC, average temperature, maximum temperature, minimum temperature, cumulative amount of charge/discharge current (Ah), and cumulative charge/discharge energy (Wh). Here, the comparison priority of history items may be defined in the order of SOC, average temperature, maximum temperature, minimum temperature, cumulative amount of charge/discharge current (Ah), and cumulative charge/discharge energy (Wh).

In the case that it is predefined as shown in the table of FIG. 7, the battery control apparatus may determine reference batteries (second batteries) as follows.

If the latest SOC of the first battery is out of the threshold SOC range, the battery control apparatus may sequentially compare history information on the SOC, history information on the average temperature, history information on the maximum temperature, history information on the minimum temperature, history information on the cumulative amount of charge/discharge current (Ah), and history information on the cumulative charge/discharge energy (Wh), until reference batteries are determined.

If the latest SOC of the first battery is within the threshold SOC range, the battery control apparatus may sequentially compare history information on the average temperature, history information on the maximum temperature, history information on the minimum temperature, history information on the cumulative amount of charge/discharge current (Ah), and history information on the cumulative charge/discharge energy (Wh), until reference batteries are determined.

Meanwhile, if reference batteries are not selected as a result of comparing the history items, a battery closest to the first battery among batteries having the same degree of similarity may be finally selected as the second battery.

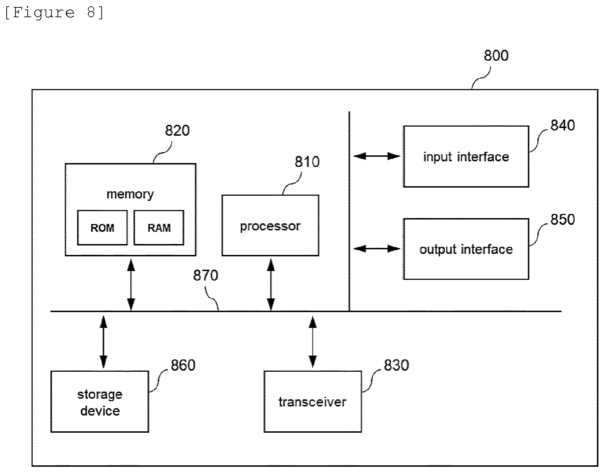

FIG. 8 is a block diagram of a battery control apparatus according to embodiments of the present invention.

The battery control apparatus 800 according to embodiments of the present invention may correspond to an upper control apparatus that is located in an energy storage system and interworks with a plurality of BMSs provided in correspondence with a plurality of batteries. For example, the battery control apparatus 800 may correspond to a battery system controller (BSC), an energy management system (EMS), or a power management system (PMS), or may be implemented by being included in any one of them.

The battery control apparatus 800 may include at least one processor 810, a memory 820 that stores at least one instruction executed by the processor, and a transceiver 830 connected to a network to perform communication.

The at least one instruction may include an instruction to collect state information on the plurality of batteries from the plurality of BMSs and monitor or control the plurality of batteries based on the collected state information; an instruction to, upon the state information of the first battery being not received from a first BMS due to a loss of communication, select second batteries among batteries connected in parallel with the first battery based on previously stored history information of batteries; and an instruction to estimate state information of the first battery based on the state information of the second batteries.

The at least one instruction may further include: an instruction to keep monitoring or controlling the plurality of batteries without stopping operation of the energy storage system even if the state information of the first battery is not received from the first BMS by using the estimated state information as the state information of the first battery.

The instruction to estimate the state information of the first battery may include: an instruction to record the estimated state information as the state information of the first battery during a period in which the state information of the first battery is not received.

The instruction to estimate the state information of the first battery includes: an instruction to calculate an average value or a median value of state of charge (SOC) values of the plurality of second batteries; and an instruction to estimate the calculated average value or the median value as a SOC of the first battery.

The instruction to select second batteries includes an instruction to select the second batteries using a distance to the first battery and history information about one or more of SOC, temperature value, and cumulative charge/discharge amount of each battery.

The instruction to select second batteries includes: an instruction to compare history information of the first battery with history information of the top N batteries with a short distance to the first battery (N is a preset natural number equal to or greater than 2) to calculate a similarity of each battery with the first battery; and an instruction to determine the top M batteries with a high similarity to the first battery as the second batteries (M is a preset natural number equal to or greater than 2).

The instruction to select second batteries may include an instruction to exclude batteries with a failure history recorded within a predetermined period from comparison among the top N batteries.

The at least one instruction may further include an instruction to renew the second batteries by replacing a failed battery with a battery having a next high similarity, if a failure occurs in a specific battery among the second batteries after the M second batteries are selected.

The instruction to select second batteries may include: an instruction to, upon not receiving a SOC of the first battery, identify the latest SOC of the first battery or of one or more batteries among the N batteries; an instruction to check whether the identified latest SOC is within a threshold SOC range predefined as an SOC estimation impossible section; and an instruction to determine the top M batteries with a high similarity to the SOC history information of the first battery, among the N batteries, as the second batteries, if the identified latest SOC is out of the threshold SOC range.

The instruction to select second batteries may further include an instruction to: upon the number of batteries having a high similarity with the SOC history information of the first battery exceeding M, determine M second batteries based on a similarity between pieces of history information on one or more of a temperature value and cumulative charge/discharge amount.

The instruction to select second batteries may include an instruction to: upon the identified latest SOC being within the threshold SOC range, determine the top M batteries having a high similarity to history information on one or more of a temperature value and cumulative charge/discharge amount of the first battery as the second batteries.

The instruction to select second batteries may include: an instruction to determine the top M batteries with a high similarity to the history information on the temperature value of the first battery as the second batteries; and an instruction to, upon the number of batteries with a high similarity exceeding M, determine M second batteries based on similarities between pieces of history information on cumulative charge and discharge amount.

The battery control apparatus 800 may further include an input interface 840, an output interface 850, a storage device 860, and the like. Respective components included in the battery control apparatus 800 may be connected by a bus 870 to communicate with each other.

Here, the processor 810 may mean a central processing unit (CPU), a graphics processing unit (GPU), or a dedicated processor on which methods according to embodiments of the present invention are performed. The memory (or storage device) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range of the appending claims.

## Claims

1. An energy storage system comprising: a plurality of batteries connected in parallel;
a plurality of battery management systems (200),BMSs, each assigned to a respective one of the plurality of the batteries, wherein the plurality of BMSs include a first BMS, wherein the plurality of batteries include a first battery and a plurality of second batteries; and
an upper control apparatus (300) configured to:
collect state information,including the state of charge, on the plurality of batteries from the plurality of BMSs and to monitor or control the plurality of batteries based on the collected state information;
upon the state of charge, SOC, information of the first battery being not received from the first BMS due to a loss of communication, select the plurality of second batteries connected in parallel with the first battery based on previously stored history information of the plurality of second batteries, calculate an average value or a median value of SOC values of the selected plurality second batteries and estimate the calculated average value or the median value as a SOC of the first battery,
wherein the upper control apparatus is configured to select the plurality of second batteries by using a distance of the plurality of second batteries to the first battery and the history information including one or more of state of charge ,SOC, temperature value, and cumulative charge/discharge amount of each battery,
wherein the upper control apparatus is configured to compare the history information of the first battery with the history information of the top N batteries of the plurality of second batteries with the shortest distance to the first battery, where N is a preset natural number equal to or greater than 2, to calculate a similarity of each battery of the top N of the
plurality of second batteries with the first battery and determine the top M batteries of the plurality of second batteries with the highest similarity to the first battery as the selected second batteries, where M is a preset natural number equal to or greater than 2,
wherein the upper control apparatus is configured to calculate similarity, for each battery of the top N of the plurality of second batteries, a similarity to the first battery by: calculating, for each time point of the history data, a difference between corresponding state values included in the history information; accumulating the calculated differences over the history data to obtain an accumulated difference value; and determining the similarity such that the similarity increases as the accumulated difference value decreases.

2. The energy storage system of claim 1, wherein the upper control apparatus is configured to keep monitoring or controlling the plurality of batteries without stopping operation of the energy storage system even if the state information of the first battery is not received from the first BMS by using the estimated state information as the state information of the first battery.

3. The energy storage system of claim 1, wherein the upper control apparatus is configured to record the estimated state information as the state information of the first battery during a period in which the state information of the first battery is not received.

4. The energy storage system of claim 1, wherein the upper control apparatus is configured to exclude batteries with a failure history recorded within a predetermined period from comparison among the top N batteries.

5. The energy storage system of claim 1, wherein the upper control apparatus is configured to renew the plurality of second batteries by replacing a failed battery with a battery having a next highest similarity, if a failure occurs in a specific battery among the plurality of second batteries after the M second batteries are selected.

6. The energy storage system of claim 1, wherein the upper control apparatus is configured to:
upon not receiving a SOC of the first battery,
identify the latest SOC of the first battery;
check whether the identified latest SOC is within a threshold SOC range predefined as an SOC estimation impossible section, wherein the SOC estimation impossible section is a section of SOC greater than 10 and less than 90; and
determine the top M batteries with the highest similarity to the SOC history information of the first battery, among the N batteries, as the second batteries, if the identified latest SOC is out of the threshold SOC range.

7. A battery control method by a battery control apparatus interworking with a plurality of battery management systems ,BMSs, each assigned to a respective one of the plurality of the batteries, the method comprising:
collecting (S510) state information,including the state of charge, on the plurality of batteries from the plurality of BMSs and monitoring or controlling (S520) the plurality of batteries based on the collected state information, wherein the plurality of BMSs include a first BMS, wherein the plurality of batteries include a first battery and a plurality of second batteries;
upon the state of charge, SOC, information of the first battery being not received from the first BMS due to a loss of communication, selecting (S540) the plurality of second batteries connected in parallel with the first battery based on previously stored history information of the plurality of second batteries, calculating an average value or a median value of SOC values of the selected plurality second batteries,
wherein the selecting the plurality of second batteries involves using a distance of the plurality of second batteries to the first battery and the history information including one or more of state of charge ,SOC, temperature value, and cumulative charge/discharge amount of each battery; and
estimating (S550) the calculated average value or the median value as a SOC of the first battery,
wherein the selecting plurality of second batteries includes:
comparing the history information of the first battery with the history information of the top N batteries with a shortest distance to the first battery, where N is a preset natural number equal to or greater than 2, to calculate a similarity of each battery of the top N of the plurality of second batteries with the first battery,
determining the top M batteries with the highest similarity to the first battery as the selected second batteries, where M is a preset natural number equal to or greater than 2,
wherein the upper control apparatus is configured to calculate similarity of each battery of the top N of the plurality of second batteries to the first battery by: calculating, for each time point of the history data, a difference between corresponding state values included in the history information; accumulating the calculated differences over the history data to obtain an accumulated difference value; and determining the similarity such that the similarity increases as the accumulated difference value decreases.

8. The method of claim 7, further comprising monitoring or controlling (S560) the plurality of batteries without stopping operation of the energy storage system even if the state information of the first battery is not received from the first BMS by using the estimated state information as the state information of the first battery.

9. The method of claim 8, wherein the estimating the state information of the first battery includes:
recording the estimated state information as the state information of the first battery during a period in which the state information of the first battery is not received.

10. The method of claim 7, wherein the selecting plurality of second batteries includes:
excluding batteries with a failure history recorded within a predetermined period from comparison among the top N batteries.

11. The method of claim 7, further comprising renewing the plurality of batteries by replacing a failed battery with a battery having a next highest similarity, if a failure occurs in a specific battery among the plurality of second batteries after the M second batteries are selected.

12. The method of claim 7, wherein the selecting the plurality of second batteries includes:
upon not receiving a SOC of the first battery, identifying the latest SOC of the first battery;
checking whether the identified latest SOC is within a threshold SOC range predefined as an SOC estimation impossible section, wherein the SOC estimation impossible section is a section of SOC greater than 10 and less than 90; and
determining the top M batteries with the highest similarity to the SOC history information of the first battery, among the N batteries, as the plurality of second batteries, if the identified latest SOC is out of the threshold SOC range.

## Patentansprüche

1. Energiespeichersystem, umfassend:
eine Mehrzahl von Batterien, welche parallel geschaltet sind;
eine Mehrzahl von Batteriemanagementsystemen (200), BMSs, welche jeweils einer jeweiligen der Mehrzahl von Batterien zugeordnet sind, wobei die Mehrzahl von BMSs ein erstes BMS umfasst, wobei die Mehrzahl von Batterien eine erste Batterie und eine Mehrzahl von zweiten Batterien umfasst; und
eine übergeordnete Steuervorrichtung (300), welche dazu eingerichtet ist:
Zustandsinformationen, welche den Ladezustand umfassen, über die Mehrzahl von Batterien von der Mehrzahl von BMSs zu sammeln und die Mehrzahl von Batterien auf Grundlage der gesammelten Zustandsinformationen zu überwachen oder zu steuern;
daraufhin, dass die Ladezustand-, SOC - state of charge, - Informationen der ersten Batterie aufgrund eines Kommunikationsverlusts nicht von dem ersten BMS empfangen worden sind, die Mehrzahl von zweiten Batterien, welche parallel zu der ersten Batterie geschaltet sind, auf Grundlage von zuvor gespeicherten Historieninformationen der Mehrzahl von zweiten Batterien auszuwählen, einen Mittelwert oder einen Medianwert von SOC-Werten der ausgewählten Mehrzahl von zweiten Batterien zu berechnen und den berechneten Mittelwert oder den berechneten Medianwert als einen SOC der ersten Batterie zu schätzen,
wobei die übergeordnete Steuervorrichtung dazu eingerichtet ist, die Mehrzahl von zweiten Batterien unter Verwendung eines Abstands der Mehrzahl von zweiten Batterien zu der ersten Batterie auszuwählen und wobei die Historieninformationen eines oder mehrere aus Ladezustand, SOC - state of charge, Temperaturwert und kumulierte Lade-/Entladungsmenge jeder Batterie umfassen,
wobei die übergeordnete Steuervorrichtung dazu eingerichtet ist, die Historieninformationen der ersten Batterie mit den Historieninformationen der N besten Batterien der Mehrzahl von zweiten Batterien mit dem geringsten Abstand zu der ersten Batterie zu vergleichen, wobei N eine vorgegebene natürliche Zahl ist, welche gleich wie oder größer als 2 ist, um eine Ähnlichkeit jeder Batterie der N besten der Mehrzahl von zweiten Batterien zu der ersten Batterie zu berechnen, und die M besten Batterien der Mehrzahl von zweiten Batterien mit der höchsten Ähnlichkeit zu der ersten Batterie als die ausgewählten zweiten Batterien zu bestimmen, wobei M eine vorgegebene natürliche Zahl ist, welche gleich wie oder größer als 2 ist,
wobei die übergeordnete Steuervorrichtung dazu eingerichtet ist, eine Ähnlichkeit für jede Batterie der N besten der Mehrzahl von zweiten Batterien zu der ersten Batterie zu berechnen, durch: Berechnen, für jeden Zeitpunkt der Historiendaten, einer Differenz zwischen entsprechenden Zustandswerten, welche in den Historieninformationen umfasst sind; Akkumulieren der berechneten Differenzen über die Historiendaten, um einen akkumulierten Differenzwert zu erhalten; und Bestimmen der Ähnlichkeit derart, dass die Ähnlichkeit zunimmt, wenn der akkumulierte Differenzwert abnimmt.

2. Energiespeichersystem nach Anspruch 1, wobei die übergeordnete Steuervorrichtung dazu eingerichtet ist, ein Überwachen oder ein Steuern der Mehrzahl von Batterien, selbst wenn die Zustandsinformationen der ersten Batterie von dem ersten BMS nicht empfangen worden sind, unter Verwendung der geschätzten Zustandsinformationen als die Zustandsinformationen der ersten Batterie beizubehalten, ohne einen Betrieb des Energiespeichersystems zu stoppen.

3. Energiespeichersystem nach Anspruch 1, wobei die übergeordnete Steuervorrichtung dazu eingerichtet ist, während eines Zeitraums, in welchem die Zustandsinformationen der ersten Batterie nicht empfangen werden, die geschätzten Zustandsinformationen als die Zustandsinformationen der ersten Batterie aufzuzeichnen.

4. Energiespeichersystem nach Anspruch 1, wobei die übergeordnete Steuervorrichtung dazu eingerichtet ist, Batterien mit einer innerhalb eines vorbestimmten Zeitraums von einem Vergleich aufgezeichneten Fehlerhistorie unter den N besten Batterien auszuschließen.

5. Energiespeichersystem nach Anspruch 1, wobei die übergeordnete Steuervorrichtung dazu eingerichtet ist, die Mehrzahl von zweiten Batterien durch ein Ersetzen einer defekten Batterie durch eine Batterie, welche eine nächsthöhere Ähnlichkeit aufweist, zu erneuern, wenn ein Fehler in einer spezifischen Batterie unter der Mehrzahl von zweiten Batterien auftritt, nachdem die M zweiten Batterien ausgewählt worden sind.

6. Energiespeichersystem nach Anspruch 1, wobei die übergeordnete Steuervorrichtung dazu eingerichtet ist:
daraufhin, dass ein SOC der ersten Batterie nicht empfangen wird,
den letzten SOC der ersten Batterie zu identifizieren;
zu prüfen, ob der identifizierte letzte SOC innerhalb eines Schwellenwert-SOC-Bereichs liegt, welcher als ein unmöglicher SOC-Schätzabschnitt vordefiniert ist, wobei der unmögliche SOC-Schätzabschnitt ein Abschnitt ist, in welchem ein SOC größer als 10 und kleiner als 90 ist; und
die M besten Batterien mit der höchsten Ähnlichkeit zu den SOC-Historieninformationen der ersten Batterie unter den N Batterien als die zweiten Batterien zu bestimmen, wenn der identifizierte letzte SOC außerhalb des Schwellenwert-SOC-Bereichs liegt.

7. Batteriesteuerverfahren durch eine Batteriesteuervorrichtung, welche mit einer Mehrzahl von Batteriemanagementsystemen, BMSs, zusammenarbeitet, die jeweils einer jeweiligen der Mehrzahl von Batterien zugeordnet sind, wobei das Verfahren umfasst:
Sammeln (S510) von Zustandsinformationen, welche den Ladezustand umfassen, über die Mehrzahl von Batterien von der Mehrzahl von BMSs und Überwachen oder Steuern (S520) der Mehrzahl von Batterien auf Grundlage der gesammelten Zustandsinformationen, wobei die Mehrzahl von BMSs ein erstes BMS umfasst, wobei die Mehrzahl von Batterien eine erste Batterie und eine Mehrzahl von zweiten Batterien umfasst;
daraufhin, dass die Ladezustand-, SOC - state of charge, -Informationen der ersten Batterie aufgrund eines Kommunikationsverlusts nicht von dem ersten BMS empfangen worden sind, Auswählen (S540) der Mehrzahl von zweiten Batterien, welche parallel zu der ersten Batterie geschaltet sind, auf Grundlage von zuvor gespeicherten Historieninformationen der Mehrzahl von zweiten Batterien, Berechnen eines Mittelwerts oder eines Medianwerts von SOC-Werten der ausgewählten Mehrzahl von zweiten Batterien;
wobei das Auswählen der Mehrzahl von zweiten Batterien ein Verwenden eines Abstands der Mehrzahl von zweiten Batterien zu der ersten Batterie involviert und wobei die Historieninformationen eines oder mehrere aus Ladezustand, SOC - state of charge, Temperaturwert und kumulierte Lade-/Entladungsmenge jeder Batterie umfassen; und
Schätzen (S550) des berechneten Mittelwerts oder des berechneten Medianwerts als einen SOC der ersten Batterie,
wobei das Auswählen der Mehrzahl von zweiten Batterien umfasst:
Vergleichen der Historieninformationen der ersten Batterie mit den Historieninformationen der N besten Batterien mit einem geringsten Abstand zu der ersten Batterie, wobei N eine vorgegebene natürliche Zahl ist, welche gleich wie oder größer als 2 ist, um eine Ähnlichkeit jeder Batterie der N besten der Mehrzahl von zweiten Batterien zu der ersten Batterie zu berechnen,
Bestimmen der M besten Batterien mit der höchsten Ähnlichkeit zu der ersten Batterie als die ausgewählten zweiten Batterien, wobei M eine vorgegebene natürliche Zahl ist, welche gleich wie oder größer als 2 ist,
wobei die übergeordnete Steuervorrichtung dazu eingerichtet ist, eine Ähnlichkeit jeder Batterie der N besten der Mehrzahl von zweiten Batterien zu der ersten Batterie zu berechnen, durch: Berechnen, für jeden Zeitpunkt der Historiendaten, einer Differenz zwischen entsprechenden Zustandswerten, welche in den Historieninformationen umfasst sind; Akkumulieren der berechneten Differenzen über die Historiendaten, um einen akkumulierten Differenzwert zu erhalten; und Bestimmen der Ähnlichkeit derart, dass die Ähnlichkeit zunimmt, wenn der akkumulierte Differenzwert abnimmt.

8. Verfahren nach Anspruch 7, ferner umfassend ein Überwachen oder ein Steuern (S560) der Mehrzahl von Batterien, selbst wenn die Zustandsinformationen der ersten Batterie von dem ersten BMS nicht empfangen worden sind, unter Verwendung der geschätzten Zustandsinformationen als die Zustandsinformationen der ersten Batterie, ohne einen Betrieb des Energiespeichersystems zu stoppen.

9. Verfahren nach Anspruch 8, wobei das Schätzen der Zustandsinformationen der ersten Batterie umfasst:
Aufzeichnen der geschätzten Zustandsinformationen als die Zustandsinformationen der ersten Batterie während eines Zeitraums, in welchem die Zustandsinformationen der ersten Batterie nicht empfangen werden.

10. Verfahren nach Anspruch 7, wobei das Auswählen einer Mehrzahl von zweiten Batterien umfasst:
Ausschließen von Batterien mit einer innerhalb eines vorbestimmten Zeitraums von einem Vergleich aufgezeichneten Fehlerhistorie unter den N besten Batterien.

11. Verfahren nach Anspruch 7, ferner umfassend ein Erneuern der Mehrzahl von Batterien durch ein Ersetzen einer defekten Batterie durch eine Batterie, welche eine nächsthöhere Ähnlichkeit aufweist, wenn ein Fehler in einer spezifischen Batterie unter der Mehrzahl von zweiten Batterien auftritt, nachdem die M zweiten Batterien ausgewählt worden sind.

12. Verfahren nach Anspruch 7, wobei das Auswählen der Mehrzahl von zweiten Batterien umfasst:
daraufhin, dass ein SOC der ersten Batterie nicht empfangen wird,
Identifizieren des letzten SOC der ersten Batterie;
Prüfen, ob der identifizierte letzte SOC innerhalb eines Schwellenwert-SOC-Bereichs liegt, welcher als ein unmöglicher SOC-Schätzabschnitt vordefiniert ist, wobei der unmögliche SOC-Schätzabschnitt ein Abschnitt ist, in welchem ein SOC größer als 10 und kleiner als 90 ist; und
Bestimmen der M besten Batterien mit der höchsten Ähnlichkeit zu den SOC-Historieninformationen der ersten Batterie unter den N Batterien als die Mehrzahl von zweiten Batterien, wenn der identifizierte letzte SOC außerhalb des Schwellenwert-SOC-Bereichs liegt.

## Revendications

1. Système de stockage d'énergie comprenant : une pluralité de batteries connectées en parallèle ;
une pluralité de systèmes de gestion de batterie (200), BMS, assignés chacun à une batterie respective de la pluralité de batteries,
dans lequel la pluralité de BMS comporte un premier BMS, dans lequel la pluralité de batteries comporte une première batterie et une pluralité de secondes batteries ; et
un appareil de commande supérieur (300) configuré pour :
collecter des informations d'état, y compris l'état de charge, sur la pluralité de batteries auprès de la pluralité de BMS et surveiller ou commander la pluralité de batteries sur la base des informations d'état collectées ;
lorsque les informations d'état de charge, SOC, de la première batterie ne sont pas reçues du premier BMS en raison d'une perte de communication, sélectionner la pluralité de secondes batteries connectées en parallèle avec la première batterie sur la base d'informations historiques précédemment stockées de la pluralité de secondes batteries, calculer une valeur moyenne ou une valeur médiane de valeurs de SOC de la pluralité de secondes batteries sélectionnée et estimer la valeur moyenne calculée ou la valeur médiane en tant que SOC de la première batterie,
dans lequel l'appareil de commande supérieur est configuré pour sélectionner la pluralité de secondes batteries en utilisant une distance de la pluralité de secondes batteries par rapport à la première batterie et les informations historiques comportant un ou plusieurs parmi un état de charge, SOC, une valeur de température et une quantité de charge/décharge cumulée de chaque batterie,
dans lequel l'appareil de commande supérieur est configuré pour comparer les informations historiques de la première batterie avec les informations historiques des N batteries prioritaires de la pluralité de secondes batteries ayant la distance la plus courte par rapport à la première batterie, où N est un nombre naturel prédéfini égal ou
supérieur à 2, pour calculer une similitude de chaque batterie des N prioritaires de la pluralité de secondes batteries avec la première batterie et déterminer les M batteries prioritaires de la pluralité de secondes batteries ayant la similitude la plus élevée avec la première batterie en tant que les secondes batteries sélectionnées, où M est un nombre naturel prédéfini égal ou supérieur à 2,
dans lequel l'appareil de commande supérieur est configuré pour calculer une similitude, pour chaque batterie des N prioritaires de la pluralité de secondes batteries, avec la première batterie en : calculant, pour chaque point temporel des données historiques, une différence entre des valeurs d'état correspondantes comprises dans les informations historiques ; cumulant les différences calculées sur les données historiques pour obtenir une valeur de différence cumulée ; et déterminant la similitude de sorte que la similitude augmente lorsque la valeur de différence cumulée diminue.

2. Système de stockage d'énergie selon la revendication 1, dans lequel l'appareil de commande supérieur est configuré pour continuer à surveiller ou à commander la pluralité de batteries sans arrêter le fonctionnement du système de stockage d'énergie même si les informations d'état de la première batterie ne sont pas reçues du premier BMS en utilisant les informations d'état estimées en tant que les informations d'état de la première batterie.

3. Système de stockage d'énergie selon la revendication 1, dans lequel l'appareil de commande supérieur est configuré pour enregistrer les informations d'état estimées en tant que les informations d'état de la première batterie pendant une période pendant laquelle les informations d'état de la première batterie ne sont pas reçues.

4. Système de stockage d'énergie selon la revendication 1, dans lequel l'appareil de commande supérieur est configuré pour exclure des batteries ayant un historique de défaillance enregistré pendant une période prédéterminée d'une comparaison parmi les N batteries prioritaires.

5. Système de stockage d'énergie selon la revendication 1, dans lequel l'appareil de commande supérieur est configuré pour renouveler la pluralité de secondes batteries en remplaçant une batterie défaillante par une batterie ayant une similitude la plus élevée suivante, si une défaillance se produit dans une batterie spécifique parmi la pluralité de secondes batteries après que les M secondes batteries sont sélectionnées.

6. Système de stockage d'énergie selon la revendication 1, dans lequel l'appareil de commande supérieur est configuré pour :
lorsqu'un SOC de la première batterie n'est pas reçu,
identifier le tout dernier SOC de la première batterie ;
vérifier si le tout dernier SOC identifié se situe dans une plage de SOC seuil prédéfinie comme une section d'estimation SOC impossible, dans lequel la section d'estimation SOC impossible est une section de SOC supérieur à 10 et inférieur à 90 ; et
déterminer les M batteries prioritaires ayant la similitude la plus élevée avec les informations historiques de SOC de la première batterie, parmi les N batteries, en tant que les secondes batteries, si le tout dernier SOC identifié est en dehors de la plage de SOC seuil.

7. Procédé de commande de batteries par un appareil de commande de batteries interagissant avec une pluralité de systèmes de gestion de batterie, BMS, assignés chacun à une batterie respective de la pluralité de batteries,
le procédé comprenant :
la collecte (S510) d'informations d'état, y compris l'état de charge, sur la pluralité de batteries auprès de la pluralité de BMS et la surveillance ou la commande (S520) de la pluralité de batteries sur la base des informations d'état collectées, dans lequel la pluralité de BMS comporte un premier BMS, dans lequel la pluralité de batteries comporte une première batterie et une pluralité de secondes batteries ;
lorsque les informations d'état de charge, SOC, de la première batterie ne sont pas reçues du premier BMS en raison d'une perte de communication, la sélection (S540) de la pluralité de secondes batteries connectées en parallèle avec la première batterie sur la base d'informations historiques précédemment stockées de la pluralité de secondes batteries, le calcul d'une valeur moyenne ou d'une valeur médiane de valeurs de SOC de la pluralité de secondes batteries sélectionnée,
dans lequel la sélection de la pluralité de secondes batteries implique l'utilisation d'une distance de la pluralité de secondes batteries par rapport à la première batterie et des informations historiques comportant un ou plusieurs parmi un état de charge, SOC, une valeur de température et une quantité de charge/décharge cumulée de chaque batterie ; et
l'estimation (S550) de la valeur moyenne calculée ou de la valeur médiane en tant que SOC de la première batterie,
dans lequel la sélection de la pluralité de secondes batteries comporte :
la comparaison des informations historiques de la première batterie avec les informations historiques des N batteries prioritaires ayant une distance la plus courte par rapport à la première batterie, où N est un nombre naturel prédéfini égal ou supérieur à 2, pour calculer une similitude de chaque batterie des N prioritaires de la pluralité de secondes batteries avec la première batterie,
la détermination des M batteries prioritaires ayant la similitude la plus élevée avec la première batterie en tant que les secondes batteries sélectionnées, où M est un nombre naturel prédéfini égal ou supérieur à 2,
dans lequel l'appareil de commande supérieur est configuré pour calculer une similitude de chaque batterie des N prioritaires de la pluralité de secondes batteries avec la première batterie en : calculant, pour chaque point temporel des données historiques, une différence entre des valeurs d'état correspondantes comprises dans les informations historiques ; cumulant les différences calculées sur les données historiques pour obtenir une valeur de différence cumulée ; et déterminant la similitude de sorte que la similitude augmente lorsque la valeur de différence accumulée diminue.

8. Procédé selon la revendication 7, comprenant en outre la surveillance ou la commande (S560) de la pluralité de batteries sans arrêter le fonctionnement du système de stockage d'énergie même si les informations d'état de la première batterie ne sont pas reçues du premier BMS en utilisant les informations d'état estimées en tant que les informations d'état de la première batterie.

9. Procédé selon la revendication 8, dans lequel l'estimation des informations d'état de la première batterie comporte :
l'enregistrement des informations d'état estimées en tant que les informations d'état de la première batterie pendant une période pendant laquelle les informations d'état de la première batterie ne sont pas reçues.

10. Procédé selon la revendication 7, dans lequel la sélection de la pluralité de secondes batteries comporte :
l'exclusion de batteries ayant un historique de défaillance enregistré pendant une période prédéterminée d'une comparaison parmi les N batteries prioritaires.

11. Procédé selon la revendication 7, comprenant en outre le renouvellement de la pluralité de batteries en remplaçant une batterie défaillante par une batterie ayant une similitude la plus élevée suivante, si une défaillance se produit dans une batterie spécifique parmi la pluralité de secondes batteries après que les M secondes batteries sont sélectionnées.

12. Procédé selon la revendication 7, dans lequel la sélection de la pluralité de secondes batteries comporte :
lorsqu'un SOC de la première batterie n'est pas reçu, l'identification du tout dernier SOC de la première batterie ;
la vérification si le tout dernier SOC identifié se situe dans une plage de SOC seuil prédéfinie comme une section d'estimation SOC impossible, dans lequel la section d'estimation SOC impossible est une section de SOC supérieur à 10 et inférieur à 90 ; et
la détermination des M batteries prioritaires ayant la similitude la plus élevée avec les informations historiques de SOC de la première batterie, parmi les N batteries, en tant que la pluralité de secondes batteries, si le tout dernier SOC identifié est en dehors de la plage de SOC seuil.
